# EUROPEAN PATENT APPLICATION

(11) **EP 0 949 662 A2**
(43) Date of publication of application: **13.10.1999**
(21) Application number: 99302362.1
(22) Date of filing: 26.03.1999
(51) Int. Cl.: H01L 21/00

(54) **Die transfer method and system**

(30) Priority: 27.03.1998 ZA 2600298
(71) Applicant: Supersensor (Proprietary) Limited, Goodwood 7460 (ZA)
(72) Inventor: Kruger, Johan Dawid, Witkoppen, 2068 Gauteng (ZA); Crooke, Michael, Durbanville 7550 (ZA)
(74) Representative: Thomson, Paul Anthony

(57) **Abstract**

A system 10 for transferring a device 12.1 to 12.5 onto a circuit 18.1, 18.2 is disclosed and claimed. The system includes a device transfer tool 26 mounted for reciprocating motion along a linear trajectory. The system further includes an optically controlled drive arrangement 31, 27, 33 for sequentially feeding one of devices 12.1 to 12.5 into line with the trajectory and an optically controlled drive arrangement 36, 27, 37 for sequentially feeding one of circuits 18.1, 18.2 to receive a device, in line with the trajectory. Controller 27 causes the device transfer tool 26 repeatedly to move along the trajectory, to transfer devices in line with the trajectory onto circuits in line with the trajectory. A method of transferring a device onto a circuit is also described and claimed.

## Description

### INTRODUCTION AND BACKGROUND

THIS invention relates to systems for and methods of assembling electronic products including a circuit onto which there is mounted at least one electronic device. The invention more particularly relates to a system for and a method of transferring the device from a carrier medium onto the circuit and of securing the device to the circuit.

In this specification the term "device" will be used to include a die separated from a wafer, a packaged integrated circuit, an electronic component etc. The term "circuit" will be used to include a substrate, which may be flexible or rigid, on which there are provided conductive leads and/or tracks and/or active and/or passive electronic components.

Prior art systems and methods of assembling electronic products include the steps of manually or semi-manually picking a device from a wafer or other form of presentation; transferring the device along a complex path; and locating and securing the device in a selected position on the circuit. This method is too slow and cumbersome for large production runs, and is usually only used in prototyping situations. Pick-and-place equipment including a gantry, an optical or visual guidance system and a robotic arm for picking the device from the wafer or other form of presentation, transferring it to a predetermined position on the circuit and locating and securing it in that position is also known. The methods used by these systems are also too slow for very large production runs of relatively cheap products (such as radio frequency (RF) transponder tags) of which very large volumes are required. A third and sophisticated system includes a revolving turret or so-called chip shooter which may be able to handle the volume and rate of production required. However, the cost occasioned by the preparation, feeding and presentation of the devices and circuits to this type of equipment increases the unit cost of an RF transponder tag significantly.

### OBJECT OF THE INVENTION

Accordingly it is an object of the present invention to provide an alternative system for and method of transferring a device onto an electronic circuit with which the applicant believes the aforementioned disadvantages may at least be alleviated.

### SUMMARY OF THE INVENTION

According to the invention there is provided a system for transferring a device onto a circuit, the system including:
- a device transfer tool mounted for reciprocating motion along a linear transfer trajectory;
- means for feeding a device to be transferred and a circuit to receive the device into line with the trajectory; and
- control means to cause the tool to move along the trajectory, to transfer the device onto the circuit.

The feeding means may include means for sequentially feeding combinations of a selected one of a plurality of devices carried by a device carrier and a selected one of a plurality of circuits carried by a circuit carrier into line with the trajectory. The feeding means may further include drive means for the device carrier; drive means for the circuit carrier; and optical detection means connected to the control means for sensing when a combination is in line with the trajectory, the control means being responsive to signals from the optical detection means to cause the tool to move the device of the combination onto the circuit of the combination.

The device carrier may include a cassette or magazine containing a plurality of separate or discrete devices. In another embodiment the devices may be mounted on and carried by a planar carrier. Such a carrier may include a lead frame or tape. In yet another embodiment a wafer of dies may be cut and stretched on a stretchable film, such as the film being sold under the trade name Nitto. The film may be mounted in a frame and the frame may be manipulatable in a plane transversely to the trajectory, to feed a selected one of the dies on the film into line with the trajectory.

The circuit carrier may include a conveyor system for feeding the circuits into line with the trajectory. The circuits may be provided in the form of a continuous web. One or more parallel, longitudinally extending rows of circuits may be provided on the web. Each circuit may have at least one placement position defined by electrical contacts thereon, for receiving a device. In some embodiments the web may be provided on and paid out from a reel.

The optical detection means may include pattern recognition means for ensuring that a contact of the device of the combination is finely aligned with a contact of the circuit of the combination.

The device transfer tool may include one or more needles for negotiating and transferring the device along the trajectory.

Also included within the scope of the present invention is a method of transferring a device onto a circuit, the method including the steps of:
- providing a device transfer tool adapted to move in reciprocating manner along a linear transfer trajectory;
- feeding a device to be transferred and a circuit to receive the device into line with the trajectory; and
- causing the tool to move along the trajectory to transfer the device onto the circuit.

The method may also include the step of securing the device in electrical contact with the circuit.

Further according to the method combinations of a selected one of a plurality of devices and a selected one of a plurality of circuits may automatically and sequentially be brought into line with the trajectory and the transfer tool may be caused automatically to transfer the device of each combination onto the circuit of that combination.

### BRIEF DESCRIPTION OF THE ACCOMPANYING DIAGRAMS

The invention will now further be described, by way of example only, with reference to the accompanying diagrams wherein
- figure 1: is a diagrammatic side view of the system according to the invention for transferring a device onto a circuit; and
- figure 2: is a diagrammatic plan view of the system.

### DESCRIPTION OF A PREFERRED EMBODIMENT

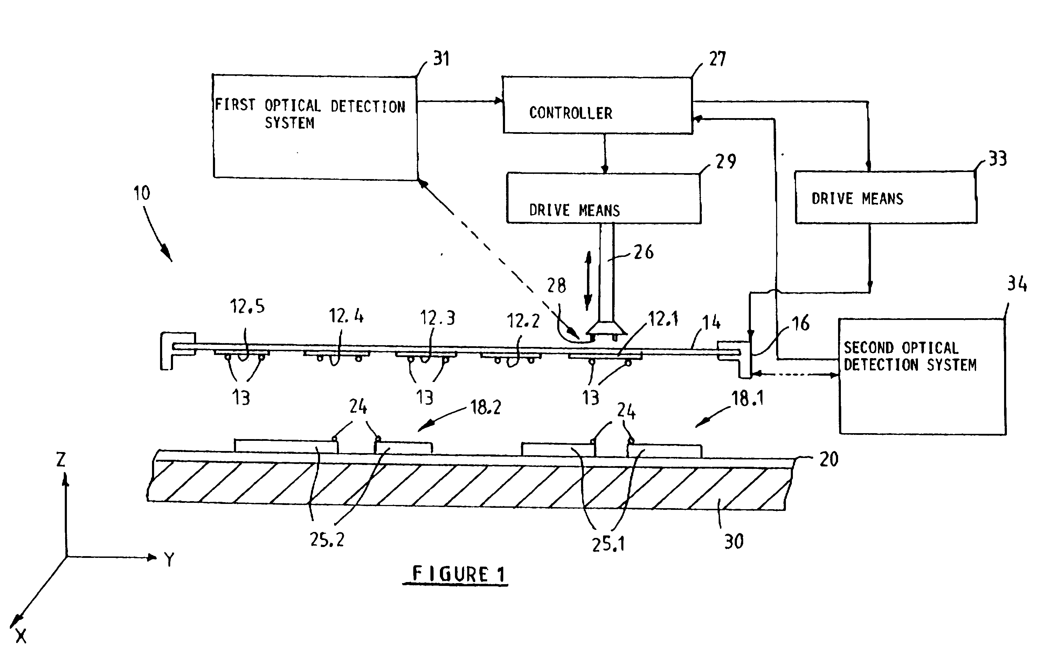

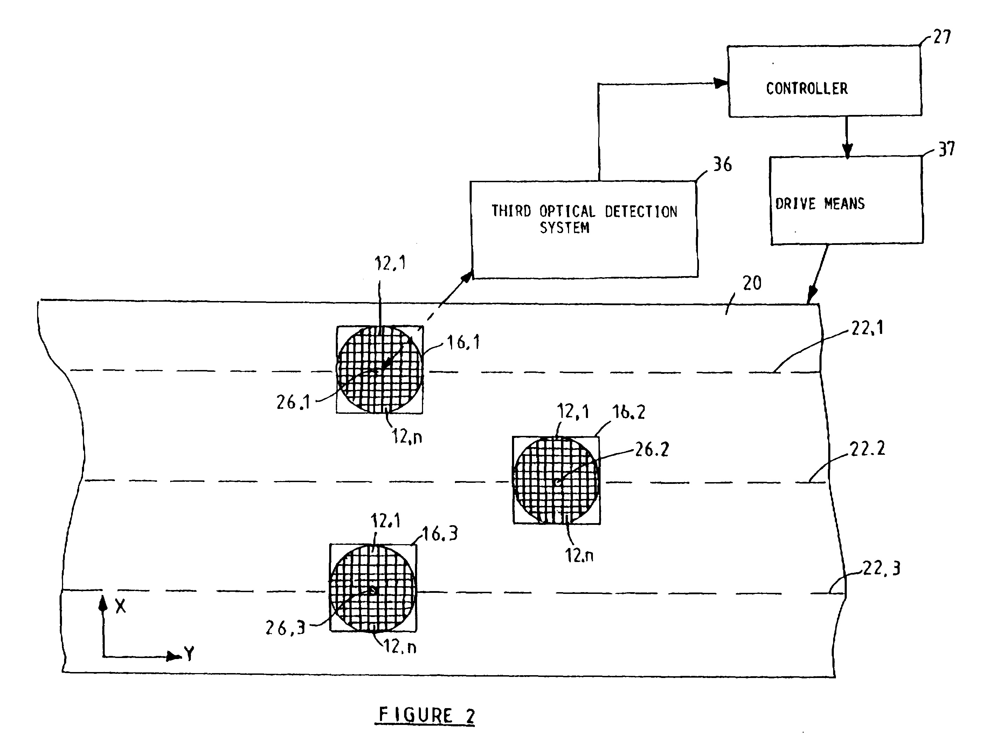

The system according to the invention for transferring a device onto an underlying circuit is designated 10 in figures 1 and 2. The system is particularly useful in transferring a naked die or packaged integrated circuit onto a flexible circuit including an antenna, to form a radio frequency (RF) transponder.

Referring firstly to figure 1, the dies 12.1 to 12.5 for the transponders cut from a wafer (not shown) and each including electronic circuitry (not shown) for a transponder and electrical contacts 13 are presented on a stretched carrier film such as Nitto tape 14. The tape 14 is held in a frame 16. The frame could be stationary in a Z-direction, but is manipulatable in an X-direction as well as a Y-direction by the system, as will hereinafter be described.

The circuits 18.1 to 18.n for the transponders are provided in three to eight rows 22.1 to 22.3 (shown in figure 2) on a continuous web 20 or substrate. The substrate is flexible and each circuit includes an antenna 25.1 to 25.2 for a transponder pre-printed on the web or substrate with screen printing techniques and utilising conductive ink. Other known techniques for providing an antenna on the substrate include the steps of die cutting and transferring a metal foil onto the substrate, alternatively etching the antenna on the substrate.

Each circuit 18.1 to 18.n has a respective placement position defined by electrical contact areas 24 on the antenna which must be brought into contact with and secured to the electrical contacts 13 of a die. The web 20 is supported on a conveyor bed 30 of the system, which is accurately moveable in the Y-direction.

The system further includes a device transfer tool 26 moveable under control of controller 27 in reciprocating manner along a linear trajectory in the Z-direction. The tool includes a plurality of needles 28 for negotiating and transferring a selected die along the trajectory.

In figure 2, there are shown three rows of circuits having centre lines 22.1 to 22.3 respectively on web 20; three frames 16.1 to 16.3 with separate dies 12.1 to 12.n stretched on Nitto tape (as hereinbefore described) located above the web; and three device transfer tools 26.1 to 26.3 for respectively transferring selected dies 12.1 to 12.n on frames 16.1 to 16.3 respectively onto circuits in rows 22.1 to 22.3 respectively. The operation of these three systems is identical.

Referring to both the figures, each device transfer tool 26 is automatically aligned by controller 27 via suitable drive means 29 and utilizing a first optical or visual detection system 31 such that it remains in line with the relevant centre line 22.1 to 22.3 through the placement positions defined by the contact areas 24 on the circuits in a row and such that at the bottom of a downward stroke of the transfer tool 26, the bottom ends of the needles 28 are in such close proximity to the contact areas 24 as to be able to push and transfer a die by the needles down onto the contact areas 24.

The dies 12.1 to 12.n on the Nitto tape 14 of each of frames 16.1 to 16.3 are sequentially brought in line with the relevant trajectory in both the X and Y directions by the controller 27 via drive means 33 for the frames and utilizing a second optical detection system 34. The second optical detection system 34 can also be used in controlling the timing of the downward movement of the device transfer tool 26.

In one embodiment the web 20 is moved in step-wise manner in the Y-direction. The timing of the movement is synchronized with the movement in the Z-direction of the device transfer tool 26. The placement positions 24 of the antennae are sensed by a third optical detection system 36 (shown in figure 2) including pattern recognition means, to cause controller 27 to cause drive means 37 to align the contact areas 24 finely with the device contacts 13.

Thus, in use, and referring to figure 1, the frame 16 is manipulated by drive means 33 such that a die 12.1 of dies 12.1 to 12.5 is located in line with the trajectory. A placement position defined by contact areas 24 on circuit 18.1 is also brought in line with the trajectory by drive means 37. The device transfer tool 26 is caused to move downwardly to depress or pierce the tape 14, thereby forcing the die 12.1 from the tape 14 onto the placement position. A bonding agent which has been previously introduced is utilized to adhere the die 12.1 to the circuit 18.1, with contacts 13 thereof in electrical contact with contact areas 24. The bonding agent may be a eutectic material that can be reflowed, conductive epoxy, a double-sided tape or any other suitable bonding agent.

Once the needles clear the tape 14 in an upward direction, the web 20 moves on one further step as hereinbefore described, to bring a next circuit 18.2 in line with the trajectory, the frame 16 is manipulated to bring a next one of dies 12.1 to 12.5 in line with the trajectory and the die transfer tool 26 is again caused to move downwardly, to secure the next die 12.2 to the next circuit 18.2 in the same manner as hereinbefore described.

As a final step in the method according to the invention individual transponders are severed from the web and from one another.

It will be appreciated that there are many variations in detail on the system and method according to the invention without departing from the scope and spirit of the appended claims.

## Claims

1. A system for transferring a device onto a circuit, the system including:
- a device transfer tool mounted for reciprocating motion along a linear transfer trajectory;
- means for feeding a device to be transferred and a circuit to receive the device into line with the trajectory; and
- control means to cause the tool to move along the trajectory, to transfer the device onto the circuit.

2. A system as claimed in claim 1 wherein the feeding means includes means for sequentially feeding combinations of a selected one of a plurality of devices carried by a device carrier and a selected one of a plurality of circuits carried by a circuit carrier into line with the trajectory.

3. A system as claimed in claim 2 wherein the feeding means includes drive means for the device carrier; drive means for the circuit carrier; and optical detection means connected to the control means for sensing when a combination is in line with the trajectory, the control means being responsive to signals from the optical detection means to cause the tool to transfer the device of the combination onto the circuit of the combination.

4. A system as claimed in claim 3 wherein the optical detection means includes pattern recognition means for ensuring that an electrical contact of the device of the combination is finely aligned with an electrical contract of the circuit of the combination.

5. A system as claimed in any one of claims 1 to 4 wherein the device transfer tool includes one or more needles for negotiating and transferring the device along the trajectory.

6. A method of transferring a device onto a circuit, the method including the steps of:
- providing a device transfer tool adapted to move in reciprocating manner along a linear transfer trajectory;
- feeding a device to be transferred and a circuit to receive the device into line with the trajectory; and
- causing the tool to move along the trajectory to transfer the device onto the circuit.

7. A method as claimed in claim 6 also including the step of securing the device in electrical contact with the circuit.

8. A method as claimed in claim 6 or claim 7 wherein combinations of a selected one of a plurality of devices and a selected one of a plurality of circuits are automatically and sequentially brought into line with the trajectory and wherein the transfer tool is caused automatically to transfer the device of each combination onto the circuit of that combination.
